# EUROPEAN PATENT SPECIFICATION

(11) **EP 1 205 583 B1**
(45) Date of publication and mention of the grant of the patent: **03.01.2007**
(21) Application number: 01126619.4
(22) Date of filing: 07.11.2001
(51) Int. Cl.: C30B 25/00, C30B 29/36

(54) **Manufacturing method for producing silicon carbide crystal using source gases and apparatus for the same**
Verfahren und Vorrichtung zur Herstellung von Siliziumkarbidkristallen unter Verwendung von Quellegasen
Procédé et appareillage pour la production des cristaux de carbure de silicium à partir des sources gazeuse

(30) Priority: 10.11.2000 JP 2000343664
(43) Date of publication of application: 15.05.2002
(73) Proprietor: DENSO CORPORATION, Kariya-city, Aichi-pref. 448-8661 (JP)
(72) Inventor: Hara, Kazukuni, Kariya-city, Aichi-pref., 448-8661 (JP); Nagakubo, Masao, Kariya-city, Aichi-pref., 448-8661 (JP); Onda, Shoichi, Kariya-city, Aichi-pref., 448-8661 (JP)
(74) Representative: Winter, Brandl, Fürniss, Hübner Röss, Kaiser, Polte Partnerschaft Patent- und Rechtsanwaltskanzlei

(56) References cited:
- WO-A-00/43577
- US-A- 5 288 326
- US-A- 6 030 661
- US-A- 6 039 812
- PATENT ABSTRACTS OF JAPAN vol. 1999, no. 05, 31 May 1999 (1999-05-31) & JP 11 035395 A (AGENCY OF IND SCIENCE &TECHNOL), 9 February 1999 (1999-02-09)

## Description

The present invention relates to manufacturing method for producing single-crystal silicon carbide that has low defects and high quality, and apparatus suitable for the same.

Silicon carbide (hereinafter, SiC) has been developed as a semiconductor substrate for a power device because SiC has characteristics such as withstanding high voltage and high electron mobility. Generally, the single-crystal SiC is produced by single crystal growth method called sublimation (the Modified Lely Method).

In the Modified Lely Method, silicon carbide source material is held in a graphite crucible, and a seed crystal is held in the graphite crucible so as to face the source material. In this state, the source material is heated up to about 2200 to 2400 °C to generate sublimed gas while temperature of the seed crystal is kept to be lower than that of the source material by several ten to several hundred °C, whereby the sublimed gas is recrystallized at a growth surface of the seed crystal to form SiC single crystals.

However, there is limit to growth in the Modified Lely Method as the source material decreases in accordance with growth of the SiC single crystals. Although new source material can be added, SiC is sublimed at a rate in which Si to C is more than 1, so that concentration of the sublimed gas vacillates when the new source material is added in process of growth, thereby preventing crystals from growing in high quality successively.

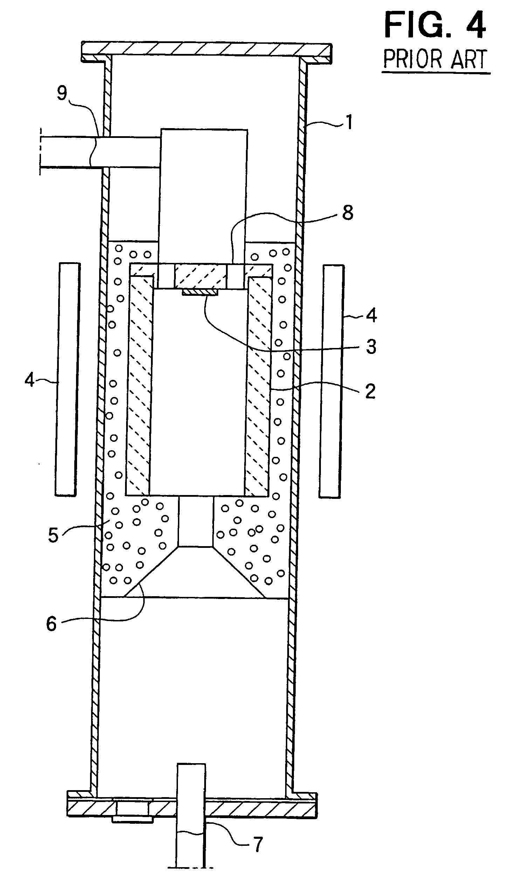

On the other hand, epitaxial growth method of SiC single crystals by CVD (Chemical Vapor Deposition) is disclosed in JP-A-11-508531 (USP 6,039,812). FIG. 4 shows a schematic cross sectional view of an apparatus for the epitaxial growth method described in the above-mentioned publication. As shown in FIG. 4, a susceptor 2 as a crucible disposed approximately at a center of a case 1 having a cylinder shape. The susceptor 2 is composed of high-purity graphite or the like. SiC single crystal substrate is disposed on an inner surface of the susceptor 2 at an upper side thereof as a seed crystal for epitaxial growth. Heater 4 is provided at an outside portion of the case 1 where the susceptor 2 is disposed inside of the case 1 to heat gases inside of the susceptor 2.

Space surrounding the susceptor 2 is filled with thermal insulator 5 composed of porous graphite. An inlet conduit 6 having a funnel shape is located under a bottom of the susceptor 2 that is formed by the thermal insulator 5. A supplying portion 7 is located at a bottom of the case 1 to supply a mixture gas while outlet conduits 8 are disposed at a top of the susceptor 2 to exhaust the mixture gas. Moreover, a conduit 9 is disposed at upper side of the case 1 that communicates with outside of the case 1.

In this apparatus constituted described above, the mixture gas supplied by the supplying portion 7 is transferred to the susceptor 2 through the inlet conduit 6 formed by the thermal insulator 5, and the mixture gas is heated by the heater 4 and epitaxial growth occurs on the seed crystal 3 as silicon carbide single crystals. Remaining mixture gas is exhausted through the outlet conduits 8 disposed at the top of the susceptor 2, and the conduit 9 disposed at the upper side of the case 1.

However, in the manufacturing method for producing silicon carbide single crystal by CVD, since the inlet conduit 6 is composed of the graphite 5, heat of the susceptor 2 tends not to transmit to the inlet conduit 6, whereby temperature of the mixture gas in the inlet conduit 6 is low. The mixture gas is heated up rapidly when transferred to the susceptor 2. When the mixture gas is heated up rapidly as described above, silicon carbide single crystals having high quality is not obtained generally.

Therefore, it is supposed that a temperature of the mixture gas is heated up in the inlet conduit 6, and then, the mixture gas having higher temperature at a degree of predetermined value is supplied to the susceptor 2. However, when the temperature of the mixture gas is 500 °C or more, Si deposits on a wall surface of the inlet conduit 6. Moreover, when mixture gas is heated up to a reaction temperature of Si and C, Si reacts with C so that SiC deposits on the wall surface of the inlet conduit 6. Thus, the inlet conduit is plugged with the deposits.

Besides, there is possibility that in a path 8 at an upper surface of the susceptor that is narrow in a passing route of the mixture gas, or in a path 9 that communicates with the outside of the upper chamber, Si which remains in the mixture gas or SiC as a product by reaction also deposits to plug those paths.

The present invention has been made in view of the above-mentioned problem, and an object thereof is to provide a manufacturing method of silicon carbide single crystals that is capable of preventing blockage caused by the mixture gas, and an apparatus for the same.

The above mentioned problem is solved by a manufacturing method for producing silicon carbide single crystals, comprising:
providing a silicon carbide single-crystal substrate (34) as a seed crystal (34) in a crucible (30);
introducing a mixture gas having a gas including Si and a gas including C into said crucible, whereby silicon carbide single crystals grow on said silicon carbide single-crystal substrate, characterized in that:
   a temperature gradient occurs in an inlet conduit (50) for introducing the mixture gas so that a temperature of the inlet conduit rises at a portion of the inlet conduit that is closer to the crucible,
wherein the temperature gradient in the inlet conduit is set at 100°C/cm or more on an average from an end portion in the inlet conduit that is disposed at the crucible to a portion at 500°C in the inlet conduit.

Preferred embodiments of the claimed manufacturing method are claimed in the subclaims.

The above mentioned problem is further solved by a manufacturing apparatus for producing silicon carbide single crystals comprising:
a crucible (30) for disposing a silicon carbide single-crystal substrate (34) therein as a seed crystal (34),
wherein
an inlet conduit (50) for introducing a mixture gas having a gas including Si and a gas including C into the crucible, so that silicon carbide single crystals grow on said silicon carbide single-crystal substrate, into the crucible; the inlet conduit having a first heat insulator (51) provided at a halfway portion of the inlet conduit for setting the temperature gradient in the inlet conduit at 100°C/cm or more on an average from an end portion in the inlet conduit that is disposed at the crucible to a portion at 500°C in the inlet conduit.

Preferred embodiments of the claimed manufacturing apparatus for producing silicon carbide single crystals are claimed in the subclaims.

According to a first aspect of the present invention a temperature gradient occurs in an inlet conduit for introducing the mixture gas so that a temperature of the inlet conduit rises at a portion of the inlet conduit that is closer to the crucible.

With this method, the mixture gas is not heated rapidly after introduced into the crucible. The mixture gas which is heated up when passing through the inlet conduit is introduced into the conduit. Therefore, silicon carbide single crystals having good quality are formed.

Moreover, even if the mixture gas is heated up to a temperature at which Si or Sic or the like can deposit in the crucible, when the mixture gas moves to a portion of the inlet conduit that is in high temperature more than a temperature at which Si and SiC can sublime, the deposit is prevented.

In the present invention, the temperature gradient is caused in the crucible so that the mixture gas moves to a portion having higher temperature, and a volume of the mixture gas expands, so that a velocity of the mixture gas in the inlet conduit increases as a temperature rises.

Therefore, the mixture gas can move to a higher temperature portion quickly, whereby a manufacturing method for producing silicon carbide single crystals is provided that is capable of preventing the inlet conduit from being plugged by the mixture gas.

Preferably, the inlet conduit has a hole in which a sectional area thereof decreases at a portion of the conduit that is closer to the crucible. According to this feature, since a path of the mixture gas tapers off at a portion of the inlet conduit that is closer to the crucible, the velocity of the mixture gas increases as the mixture gas approaches the crucible. Therefore, the velocity of the mixture gas is enhanced more than that of the mixture gas in a case where a sectional area of the hole in the inlet conduit is constant.

Preferably, the mixture gas is mixed with a carrier gas to be introduced together into the crucible through the inlet conduit.

According to this feature, a velocity of the mixture gas is enhanced in the inlet conduit. Therefore, the mixture gas is prevented from being plugged the inlet conduit.

Preferably, a temperature at an exhaust portion of the crucible through which the mixture gas is introduced into the crucible is set higher than that at an introducing portion of the crucible through which the mixture gas is exhausted from the crucible.

Since the deposits caused by the mixture gas tend to be formed at a portion at low temperature in comparison with a periphery thereof, the exhaust portion is prevented from being plugged with the deposits by increasing the temperature at the exhaust portion.

Preferably, a movable temperature rising means and an x-ray apparatus are provided outside the crucible to reduce deposits caused by the mixture gas.

Preferably, a room for passing the mixture gas therein that is exhausted from a growth room where silicon carbide single crystals grow on the silicon carbide single-crystal substrate, and a temperature of the room is set lower than that of the growth room, so that deposits due to the mixture gas are formed in the room.

Deposits caused by the mixture gas tend to be formed at a portion at low temperature. Therefore, by forming the deposits in this room, an exhaust conduit for exhausting the mixture gas to the outside of the apparatus is prevented from being plugged with the deposits due to the mixture gas. Incidentally, since the deposits are formed on a wall of the room, a path of the gas is secured in the room.

An apparatus in this invention has a crucible for disposing a silicon carbide single-crystal substrate therein as a seed crystal, wherein a mixture gas having a gas including Si and a gas including C is introduced into the crucible, so that silicon carbide single crystals grow on said silicon carbide single-crystal substrate; and
an inlet conduit for introducing the mixture gas into the crucible, the inlet conduit having a first heat insulator provided at a halfway portion of the inlet conduit for setting a temperature gradient therein so that temperature of the inlet conduit at a side of the crucible is higher than that of the inlet conduit at an opposite side with respect to the crucible,
wherein the temperature gradient in the inlet conduit is set at 100°C/cm or more on an average from an end portion in the inlet conduit that is disposed at the crucible to a portion at 500 °C in the inlet conduit.

Plurality of materials, such as graphite, quartz, or metal or the like, each of which has different thermal conductivity from each other can employ to the inlet conduit to make the temperature gradient therein suitably. In this case, the graphite should be located nearest the crucible because of its high heat resistance. Preferably, the quartz is intervened between the graphite and the metal.

Preferably, a sectional area of a hole formed in the inlet conduit decreases at a portion of the inlet conduit that is closer to the crucible. Thus, the velocity of the mixture gas is enhanced.

Preferably, TaC is formed on an inner surface at least at an outlet portion in the inlet conduit.

Preferably, a surface roughness should be regulated. For example, 7 µm or less.

Preferably, an inner surface of the inlet conduit may be a polished surface, or a mirror surface.

Preferably, a protrusion is formed inside the crucible, and the protrusion has a communicating path which connects the inlet conduit to the growth room. Besides, an opening area of the communicating path increases at a portion thereof that is closer to the silicon carbide single-crystal substrate, and a wall surface of the communicating path has a convex and concavity thereon. With this feature, deposits due to the mixture gas are trapped at the convex and concavity surface, whereby the inlet conduit is prevented from being plugged with the dropped deposits.

Other objects and features of the present invention will become more readily apparent from a better understanding of the preferred embodiment described below with reference to the following drawings.
FIG. 1 is a schematic cross sectional view of a manufacturing apparatus in the first embodiment of the present invention;
FIG. 2 is a schematic cross sectional view of a manufacturing apparatus in the second embodiment of the present invention;
FIG. 3 is a schematic cross sectional view of a manufacturing apparatus in the third embodiment of the present invention; and
FIG. 4 is a schematic cross sectional view of a manufacturing apparatus in the prior art.

### (FIRST EMBODIMENT)

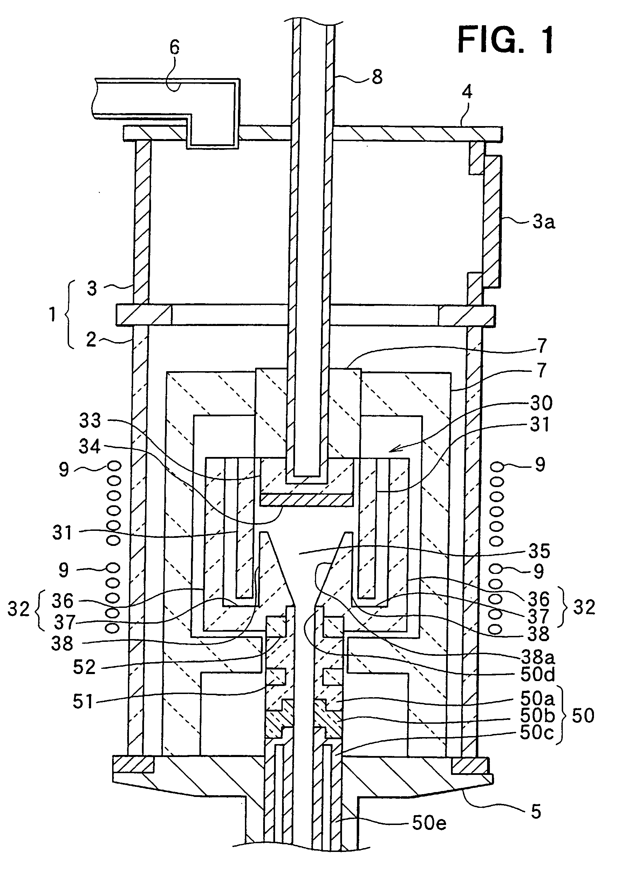

Hereinafter, an embodiment will be explained. FIG. 1 shows an apparatus for producing silicon carbide single crystals (hereinafter, merely referred to as an apparatus). As shown in FIG. 1, cylindrical chamber 1 has a lower chamber 2 that is a portion to hold a crucible, and an upper chamber 3 that is a portion to take out a completed silicon carbide (SiC) so that space formed in the lower chamber 2 communicates with space formed in the upper chamber 3.

The upper chamber 3 is composed of, for example, a SUS (stainless steel), and has a sample take-out port 3a for taking out SiC single crystals that finishes crystal growth. An opening at an upper side of the upper chamber 3 is covered with a top lid 4 composed of, for example, the SUS (stainless steel). An exhaust pipe 6 is connected to the top lid 4, and is connected to a vacuum pump (not shown). An inside of the chamber 1 is controlled in pressure by the vacuum pump so as to draw a vacuum.

The lower chamber 2 is composed of, for example, quartz, and an opening at a lower side for the lower chamber 2 is covered with a bottom lid 5 composed of, for example, the SUS (stainless steel). The crucible 30 is disposed inside the lower chamber 2 and surrounded by a heat insulating material.

The crucible has first member 31 and second member 32. The first member 31 has a cylindrical body (first cylindrical member) . A SiC single crystal substrate fixing pedestal 33 (hereinafter, merely referred to as a pedestal) is disposed at a side close to the upper chamber 3 inside the first member 31 so that gap is formed between the pedestal 33 and inner wall of the upper chamber 3. A silicon carbide single crystal substrate 34 is fixed on one surface of the pedestal 33. The SiC single crystals grow on the silicon carbide single crystal substrate 34 as a seed crystal in space 35 provided inside the first member 31. Hereinafter, the silicon carbide single crystal substrate 34 is referred to as a seed crystal, the space 35 inside the first member 31 is referred to as a growth room.

The second member 32 has a cylindrical body (second cylindrical member) 36 and a wall 37. The wall 37 is provided at an end located far from the upper chamber 3 in the cylindrical body 36. A protrusion 38 is provided at a center portion of a wall 37 in the second member 32. The protrusion 38 is provided so as to protrude to the inside of second cylindrical body 36, and a communicating path 38a, which communicates with the inside of the second cylindrical body 36 to the outside of second member 32, is formed inside the protrusion 38. The communicating path 38a is constituted in such a manner that an opening area of the communicating path 38a increases at a portion of the communicating path 38a that is closer to the pedestal 34. The first member 31 is disposed inside the second member 32 described above. More specifically, the first member 31 intervenes between the second cylindrical body 36 and the protrusion 38, and a gap is formed between a wall 37 and a tip portion of the first member that is located at a side of the wall 37. Thus, the protrusion 38 is set to protrude from the wall 37 to a seed crystal 34, and a structure is provided in such a manner that the outside of the crucible 30 communicates with the growth room 35 through the communicating path 38a.

Incidentally, a portion of the first cylindrical body at the side of the upper chamber 3 and a portion of the second cylindrical body at the side of the upper chamber 3 are connected with each other to unite with each other.

Such the crucible 30 is constituted as follows, in other words. That is, the crucible 30 has a cylindrical member corresponding to the first member 31 a glass-shaped member corresponding to the second member 32. The cylindrical member is disposed inside the glass-shaped member, an end portion at an inlet side of the glass-shaped member and one end portion of the cylindrical member are positioned at the same plane, and a gap is formed between the other end portion of the cylindrical member and a bottom of the glass-shaped member. Besides, the protrusion 38 is formed approximately at a center of a bottom of a glass-shaped member corresponding to the second member 32 to protrude to a direction of an open end of the glass-shaped member, and the communicating path 38a, which communicates with the outside of the crucible 30 and a space (growth room 35) formed inside a cylindrical body corresponding to the first member 31, is formed in the protrusion 38.

Incidentally, high purity graphite capable of withstanding high temperature (for example, approximately 2400 °C) can be employed to material for the first member 31. By using the high purity graphite, it is reduced that impurity comes out from the crucible 30 and is taken into the crystals during growth.

On the other hand, an inlet conduit 5 is connected to the wall 37 of the second cylindrical member 36 so that the inlet conduit 50 communicates with the growth room 35. The mixture gas for crystal growth of SiC is introduced to the growth room 35 through the inlet conduit 50 and the communicating path 38.

The inlet conduit 50 is constituted in such a manner that a temperature gradient occurs so that a temperature of the inlet conduit 50 rises at a portion in the inlet conduit 50 that is closer to the crucible 30. In this embodiment, the inlet conduit 50 is composed of three parts. Starting from an outlet portion 50d where the mixture gas is exhausted into the growth room 35, first inlet conduit 50a, second inlet conduit 50b, and third inlet conduit 50c are arranged in this order.

The first inlet conduit 50a is located at a top portion of the inlet conduit 50 where the outlet portion 50d is located, and therefore, disposed close to the crucible 30. Accordingly, the first inlet conduit 50a is composed of material capable of withstanding high temperature such as, for example, graphite. First thermal insulator 51 is disposed so that the temperature gradient occurs in the first inlet conduit 50a.

Moreover, second thermal insulator 52 is disposed between the first inlet conduit 50a and the crucible 30. Thus, amount of heat transfer from the crucible 30 that is heated up to high temperature to the first inlet conduit 50a is reduced, whereby the temperature gradient preferably occurs in the first inlet conduit 50a.

By such the structure, temperature at a portion in the first inlet conduit 50a that is located under the fist heat insulator 51 can be set at 500 °C. Specially, porous graphite can be employed as a material for the first and second heat insulator 51 and 52.

The second inlet conduit 50b is provided to restrain heat conduction from the first inlet conduit 50a to the third inlet conduit 50c. Therefore, the second inlet conduit 50b is composed of a material that has low thermal conductivity such as, for example, quartz. The third inlet conduit 50c is composed of, for example, metal, more specially, SUS (stainless steel). The third inlet conduit 50c is equipped with, for example, a cooling structure that cools down the third inlet conduit 50c with water, for example.

Here, when surface roughness Ra is set as an average of difference in dimension between protruding portions and hollow portions at a surface of the inside of the inlet conduit 50 along a direction perpendicular to the surface thereof, the surface roughness Ra of the inner surface of the inlet conduit 50 is set at 7 µm or less, preferably 1 µm or less.

This is because, especially in the first inlet conduit 50a, temperature of the mixture gas rises at high (for example, 500 °C or more), so that deposits of the mixture gas tend to deposit on the inner surface of the first inlet conduit 50a. Therefore, when the surface roughness Ra is restrained, contact area is reduced where the mixture gas contacts to the inner surface of the first inlet conduit 50a, so that flow velocity of the mixture gas near the inner surface of the first inlet conduit 50 is prevented from being lowered. As a result, the inlet conduit 50 is prevented from being plugged.

Further, a portion of the inlet conduit 50 at an opposite side of the outlet portion 50d penetrates a lower lid 5 to reach an external of the chamber 1. Although not shown, a mass flow controller is equipped that is located at a further lower side to control flow of the mixture gas that flows into the inlet conduit 50. Moreover, although not shown, a pyrometer is equipped that is located under the inlet conduit 50 to measure temperature at a surface of the SiC single crystals in process of crystallization or the surface of the seed crystal 34 through the inlet conduit 50.

A lifting shaft (hereinafter, merely referred to as a shaft) 8 is fixed to other side of the pedestal 33 that is opposite to the side where the seed crystal 34 is fixed, to lift the seed crystal 34 to a direction opposite to a growth direction of the SiC single crystals. The shaft 8 has a tube shape, a portion thereof close to the crucible 30 is composed of quartz, and a portion far from the crucible 30 is composed of SUS (stainless steel). A pyrometer is equipped at an upper side of the shaft 8 to measure temperature of the pedestal 33. Incidentally, the shaft 8 is also surrounded with the heat insulator 7 in the neighborhood of the crucible 30.

A temperature rising means 9 is provided outside the chamber 1, which is located at the same level to the crucible 30. An RF (Radio Frequency) coil 9 is employed as the temperature rising means 9. In this embodiment, the RF coil has an upper coil and a lower coil independent with each other, so that temperature of an upper portion of the chamber 1 is controlled independent from that of a lower portion of the chamber 1. Moreover, although not shown, an x-ray apparatus is disposed outside the chamber 1.

Next, manufacturing method of SiC single crystals will be explained, which is performed using such the manufacturing apparatus. First, the seed crystal 34 is fixed on the one surface of the pedestal 33, and disposed at a predetermined position inside the growth room 35 by positioning using the shaft 8.

Next, the inside of the chamber 1 is vacuumed while Ar gas is introduced through the inlet conduit 50. After that, the crucible 30 is inductively heated up by applying electrical power to the RF coil 9. Then, temperature of the crucible 30 is stabilized at a predetermined temperature (above 1420 °C that is a temperature in melting point of Si, preferably approximately at 2400 °C where SiC can sublime), and pressure in the crucible 30 is set at a predetermined pressure. Incidentally, since the crucible 30 is surrounded with the heat insulator 7, the crucible 30 is set at high uniform temperature easily. The temperature gradient occurs in the inlet conduit 50 so that temperature therein increases at the portion in the inlet conduit 50 that is closer to the crucible 30. More specifically, the temperature gradient in the inlet conduit 50 is 100 °C/cm or more on an average from an end portion in the inlet conduit that is disposed at the crucible 30 to a portion at 500 °C in the inlet conduit 50. This temperature gradient may be further steep, i.e., may be 500 °C/cm or more.

In this embodiment, the first and second heat insulators 51 and 52 are disposed at the crucible 30. The porous graphite is capable of withstanding high temperature and is porous, thereby being prevented from being inductively heated up by the RF coil 9. Therefore, by employing the porous graphite as the heat insulators 51 and 52, the temperature gradient preferably occurs in the inlet conduit 50. Incidentally, temperature at a portion in the first inlet conduit 50a under the first heat insulator 51 is set approximately at 500 °C.

The mixture gas is introduced into the crucible 30 with carrier gas through the inlet conduit 50. The mixture gas includes a gas containing Si and a gas containing C. Specially, SiH₄, C₃H₈, H₂, and N₂ are used as the mixture gas.

In these gases, SiH₄ and C₃H₈ are the gases for forming SiC single crystals. Moreover, H₂ forms hydrocarbon by combining with excess carbons at a surface of SiC single crystal so that H₂ prevents the surface of SiC single crystal from being carbonized. Moreover, N₂ is a dopant gas and introduced to form n-type conductive SiC. Incidentally, trimethylaluminium gas or the like is used and introduced Al to form p-type conductive SiC.

Incidentally, the carrier gas is used for increasing gas flow in the inlet conduit 50, and Ar is employed, for example.

As described above, by introducing the mixture gas into the crucible 30 through the inlet conduit 50 where the temperature gradient occurs, the mixture gas is not heated up rapidly after introduced into the crucible 30, but the mixture gas at high temperature that is heated up when passing through the inlet conduit 50. Therefore, silicon carbide single crystals having high quality can be formed.

In this case, when the temperature of the mixture gas rises and exceeds such a degree at 500 °C, there is possibility that Si deposits on the inner surface when SiH₄ bumps against the inner surface of the inlet conduit 50. However, the depositions thereof are prevented if the mixture gas is transferred to a high temperature region of the inlet conduit at which temperature thereof is a sublimation point or a melting point of Si and SiC sublime before the depositions thereof occur. The temperature at the high temperature region of the inlet conduit described above is 1800 °C where SiC can sublime.

In this embodiment, the mixture gas is transferred to a higher temperature region by generating the temperature gradient in the inlet conduit 50. Volume of the mixture gas is expanded as temperature thereof rises. Therefore, the flow velocity of the mixture gas increases as the temperature thereof rises. Moreover, since the carrier gas is mixed with the mixture gas, the flow velocity in the inlet conduit 50 can be faster.

More specifically, a flow velocity of the mixture gas at the end portion of the inlet conduit 50 that is disposed at the side of the crucible 30 is preferably 50 cm/s or more, 500 cm/s or more, more desirably.

As described above, the mixture gas can be transferred to the higher temperature region, so that the inlet conduit 50 is prevented from being plugged with the mixture gas.

Incidentally, the mixture gas that is introduced into the crucible 30 through the inlet conduit 50 is crystallized on the seed crystal or the SiC single crystals that has already been crystallized on the seed crystal. Crystallinity of the SiC single crystals in this time varies based on crystallinity of the seed crystal 34 or a condition of the temperature in the crucible 30 or the like, so that the SiC single crystals grow as 4H-SiC or 6H-SiC or the like.

After that, the mixture gas passes through the gap between the protrusion 38 and the tip portion of the first member 31, the gap formed between the tip portion of the first member 31 and the wall 37 of the second member 32 (the bottom of the glass-shaped member), and the gap between the outer wall of the first member 31 and the inner wall of the second cylindrical portion 36, then, the mixture gas is exhausted to the outside of the crucible 30.

Generally, deposits (for example, that are composed of solidified ingredients of polycrystalline silicon or the like in the mixture gas) caused by the mixture gas tend to accumulate on a portion where temperature thereof is lower than other portions on the periphery thereof. Therefore, in this embodiment, by adjusting each output of RF coils that are independent from each other in high and low, temperature of the mixture gas exhausted from the crucible at an exhaust portion of the crucible 30 is higher than that of the mixture gas introduced into the crucible 30 at an introducing portion of the crucible 30. Incidentally, in the embodiment shown in the drawing, the introducing portion denotes a portion in the wall 37 that is connected to the inlet conduit 50, and the exhaust portion denotes the gap formed with first member 31 and the second cylindrical body 36.

As described above, the exhaust portion is prevented from being plugged with the deposits caused by the mixture gas when the mixture gas is exhausted from the crucible 30 by rising the temperature at the exhaust portion. Namely, since SiC vapor pressure becomes high at a high temperature portion, polycrystalline silicon is prevented from being deposited on the exhaust portion so that the gas is exhausted from the crucible 30 smoothly.

Then, when the crystal growth is stopped, the mixture gas is stopped being supplied and the temperature is lowered by decreasing electrical power supply of the RF power. After that, the SiC single crystals is transferred to the upper chamber 3, and pressure in the upper chamber 3 is risen to atmospheric pressure, and then, the SiC single crystals are taken from the sample take-out port 3a.

As described above, a blockage due to the mixture gas at the inlet conduit 50, and a blockage due to the mixture gas at the exhaust portion are prevented, so that SiC single crystals are grown.

Incidentally, during the crystal growth, temperature of the seed crystal 34 or the SiC single crystals is measured by the pyrometer equipped beneath the inlet conduit 50, and the temperature can be set under that of the crucible 30. Therefore, although change in temperature caused by an arrangement of crucible 30 and pedestal 33 or by deterioration with heat may occur, the mixture gas can be crystallized on the surface of the seed crystal 34 or the SiC single crystals at constant temperature.

Moreover, since an opening of the communicating path 38a that is disposed at a side of the growth room 35 is larger than that of the communicating path 38a that is disposed at a side of the inlet conduit 50, the flow velocity of the mixture gas can be slower around the seed crystal 34. Thus, the mixture gas can stay at around the seed crystal 34 for a long time, so that a lot of SiH₄ and C₃H₈ in the mixture gas can be contributed to form SiC single crystals.

Moreover, since the deposits are prevented from being formed at the inlet conduit 50 or the exhaust portion of the crucible 30, the mixture gas is reduced to be used up except the growth of SiC single crystals.

Incidentally, in the manufacturing apparatus described above, the pedestal 33 is connected to the shaft 8 so as to be lifted up to an upper direction (direction of the upper chamber 3) according to progress of the crystal growth of SiC single crystals. Therefore, the crystals can grow long successively.

### (Second Embodiment)

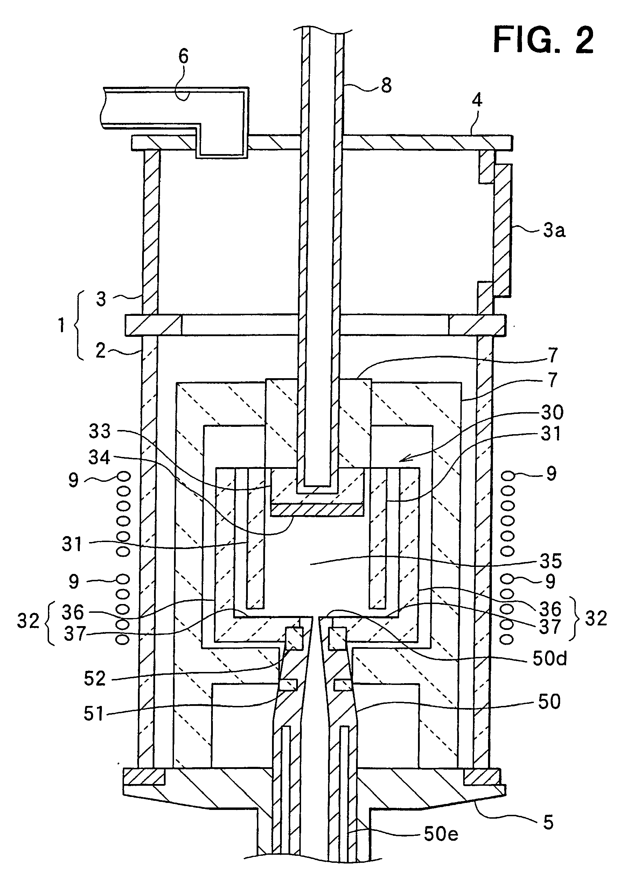

FIG. 2 shows a schematic cross sectional view of a manufacturing apparatus regarding second embodiment. Hereinafter, different portions from the first embodiment are described mainly, and the same component parts are designated by the same reference numerals so that description thereof is omitted.

In this embodiment, an inlet conduit 50 is different in shape of an end portion thereof from that in the first embodiment. As shown in FIG. 2, a sectional area of an inlet conduit 50 decreases at a portion thereof that is closer to a crucible 30.

Thus, since a path of a mixture gas tapers off at a portion of the inlet conduit that is closer to the crucible 30, flow velocity of the mixture gas increases at the portion of the inlet conduit that is closer to the crucible 30. Therefore, in comparison with a case in which sectional area of hole in the conduit 50 is constant as the first embodiment, the flow velocity of the mixture gas can further increase at an end portion of the inlet conduit 50, so that blockage caused by the mixture gas in the inlet conduit 50 is prevented.

Incidentally, the inlet conduit 50 in this embodiment is not constructed with different three parts as the first embodiment, but constructed with one or two parts. In addition, a first heat insulator 51 is provided at a halfway portion of the inlet conduit 50. Moreover, a second heat insulator 52 is provided between the crucible 30 and the inlet conduit 50. By constructing in the manner described above, a temperature gradient may occur in the inlet conduit 50.

Incidentally, although the inlet conduit 50 in this embodiment is constructed with one or two parts, preferably, surface roughness of an inner surface of the inlet conduit 50 is controlled similarly to the first embodiment at a portion having a temperature gradient. More specifically, since deposits tend to be formed at a portion at which temperature exceeds such a degree at 500 °C, the portion should be controlled in temperature preferably.

Incidentally, a protrusion 38a is not provided in the crucible 30. Even if such the structure, SiC single crystals are produced sufficiently.

Further, the gap formed between a wall 37 and a tip portion of the first member 31 is narrowed to such a degree that flow rate of the gas is limited. Therefore, the mixture gas in the growth room 35 tends not to be exhausted from the crucible 30. As a result, the mixture gas stays in the growth room 35 for a long time, so that a lot of SiC single crystals are crystallized and grown from the mixture gas.

Incidentally, with regard to the surface roughness Ra of the inner surface in the inlet conduit 50, it is not necessarily to control a whole portion where the temperature gradient occurs in the inlet portion 50, but it is preferable to control at least at an exit 50d as a portion where sectional area of the hole in the inlet conduit 50 is smallest so that deposits tend to plug.

### (Third Embodiment)

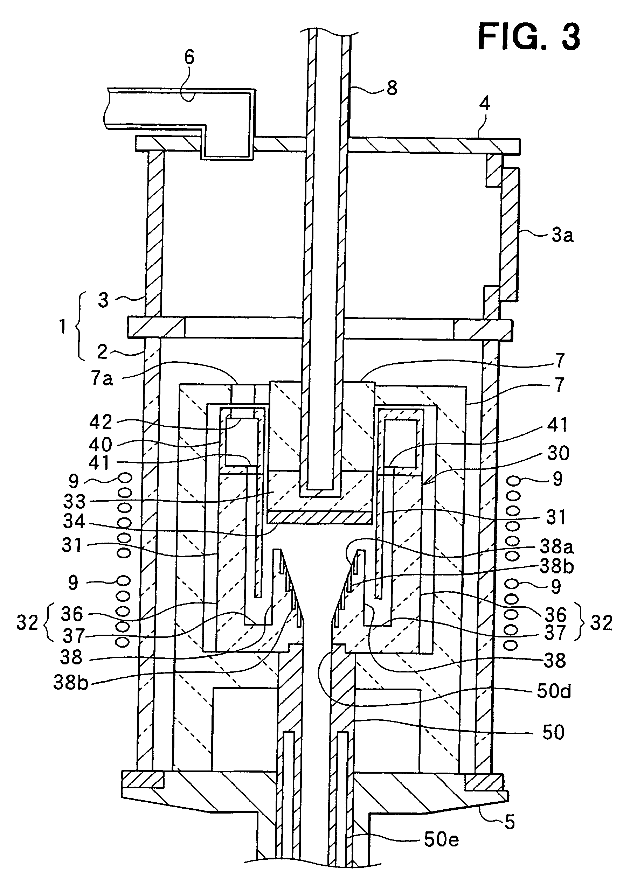

FIG. 3 shows a schematic cross sectional view of a manufacturing apparatus regarding third embodiment. Hereinafter, different portions from the first embodiment are described mainly, and the same component parts are designated by the same reference numerals so that description thereof is omitted.

In this embodiment, a protrusion 38 is different in shape of a wall surface of a communicating path 38a from that in the first embodiment. As shown in FIG. 3, the wall surface of the communicating path 38a has a convex and concavity face therein. More specifically, slot-shaped grooves 38b is formed to face a seed crystal 34.

Generally, when a mixture gas is supersaturated in a growth room 35, the mixture gas 30 bumps against a wall of the crucible 35, so that deposits are formed on this wall. When the mixture gas is supplied through the communicating path 38a of the protrusion 38 protruding to a side of the seed crystal 34 in the crucible 30, there is possibility that the deposits are formed on the wall surface of the communicating path 38a, so that the deposits fall so as to plug the inlet conduit 50.

However, in this embodiment, by providing the grooves 38b to the wall surface of the communicating path 38a, the deposits are trapped in the grooves 38b, so that the inlet conduit 50 is prevented from being plugged with the dropped deposits. Moreover, the deposits trapped in the grooves 38b may be sublimed and used to a growth of SiC. Incidentally, steps may be formed on the wall surface of the communicating path 38a instead of the grooves 38b.

Moreover, in this embodiment, as shown in FIG. 3, a gas trap 40 is provided at a side of the upper chamber 3 as a room for passing the gas exhausted from the growth room 35 through. The gas trap 40 is lowered in temperature in comparison with the growth room 35. Furthermore, in the gas trap 40, an opening 41, which communicates with an exhaust portion of the crucible 30, is formed on one face located at a side close to the crucible 30, and an opening 42 is formed on other face located at a side opposite to the crucible 30. An opening 7a is formed in a heat insulator 7 so as to be located in accordance with the opening 42.

As described above, since the gas trap 40 is provided, the mixture gas exhausted from the crucible 30 passes through the gas trap 40. Since deposits due to the mixture gas tend to accumulate at a portion where temperature is low, the deposits accumulate on the gas trap 40. Therefore, constituents of the mixture gas are solidified so that concentration of the constituents in the mixture gas can be reduced. As a result, an exhaust conduit 6 is prevented from being plugged with the deposits due to the mixture gas.

Furthermore, since the deposits accumulate on a wall of the gas trap 40, a flow path of the gas in the gas trap 40 is secured sufficiently. Moreover, the gas trap 40 may be provided as a separated body from the crucible 30 so as to be changed for a new one when amount of the deposits increases.

Incidentally, in the above-mentioned embodiments, although the heat insulators 51 and 52 are provided to the inlet conduit 50 to cause the temperature gradient therein suitably, as shown in FIG. 3, it is not necessarily to provide the heat insulators 51 and 52.

### (Other Embodiments)

In each embodiment described above, the RF coil 9 is provided movably. Portions where the deposits based on the mixture gas are formed in the crucible 30 are checked using an x-ray apparatus, so that temperature of the portions where the deposits are formed rises.

Thus, the deposits are sublimed by increasing the temperature thereof, so that the deposits are reduced, whereby blockage of the crucible 30 is prevented.

Moreover, TaC or the like is formed on an inner wall of the inlet conduit 50 to constitute the inner wall of the inlet conduit 50, and a surface roughness of the TaC may be controlled similarly to each above-mentioned embodiment. Specially, as the first embodiment, when a surface roughness Ra of the inner surface of a portion in the inlet conduit 50 that is composed of graphite is controlled, it is preferable that TaC is formed on the inner surface and the surface roughness Ra of the inner surface is controlled.

Further, a surface roughness Ra of an end portion of the inlet conduit 50 (for example, that is composed of graphite) can be controlled, or a surface roughness Ra of an entire inner surface of the inlet conduit 50 can be controlled.

Further, in the above-mentioned embodiments, although Ar gas is employed as the carrier gas, inert gas such as He or the like can be employed in addition to Ar gas. Furthermore, although H₂ gas is included in the mixture gas, H₂ gas may be employed as a carrier gas. Since both H₂ and He have high thermal conductivity in comparison with SiH₄ and C₃H₈, these gases can absorb heat on the seed crystal 34 or the SiC single crystals when reaching. Therefore, surface of the seed crystal 34 or the SiC single crystals is cooled down in comparison with the crucible 30, the crystal growth of SiC is encouraged.

### [Example]

First, the seed crystal 34 was fixed to the pedestal 33, and disposed at a predetermined place in the crucible 30. At that time, the seed crystal was disposed so that a (0 0 0 1) Si face of 6H-SiC faces the growth room 35.

Then, the chamber 1 was vacuumed, and Ar was introduced into the chamber 1 at a rate of 10 litres per minute through the inlet conduit 50. Moreover, electrical power was supplied to the RF coil 9, so that the crucible was heated up to 2400 °C.

After that, when temperature of the crucible 30 became stable at 2400 °C, pressure in the chamber 1 was set at 2.66 x 10⁴ Pa, and the mixture gas and the carrier gas described above were introduced into the crucible 30 while flows thereof were controlled by the mass flow controller. The flows of SiH₄, C₃H₃, H₂ gas, N₂, and Ar were set to 1 litre per minute, 0.27 litres per minute, 1 litre per minute, 0.4 litres per minute, and 5 litres per minute, respectively.

During the crystal growth, surface temperature of the seed crystal 34 or the SiC single crystals grown on the seed crystal 34 were measured by the pyrometer disposed beneath the inlet conduit 50, and controlled to be at 2350 °C. Moreover, temperature distribution and gas concentration distribution were uniformed at the surface of the seed crystal 34 or the SiC single crystals grown on the seed crystal 34 by rotating the shaft 8.

When one hour passed after start of the crystal growth, crystal growth amount was monitored during the crystal growth by observing a transmission image of the crucible 30 using an x-ray apparatus. As a result, growth rate was at 1.5 mm/hour based on the growth amount. The crystal growth was continued while the shaft 8 was lifted up according to the growth rate.

The crystal growth had been performed for 40 hours as described above, then supplies of SiH₄, C₃H₈, H₂ gas, N₂, and Ar gases were stopped, and the temperature was decreased by lowering the electric power of the RF power. After that, the SiC single crystals was transferred to the upper chamber 3, and pressure in the upper chamber 3 was risen to atmospheric pressure, and then, the SiC single crystals were taken from the sample take-out port 3a.

After the experiment described above, the growth amount of the SiC single crystals was measured to be at 57 mm. The fact was found that a taken-out ingot of the SiC single crystals had temperature distribution and gas concentration distribution symmetrically with respect to a center thereof since the ingot had a facet of a (0 0 0 1) face at a grown surface thereof.

Moreover, a wafer having a thickness of 500 µm was sliced from the SiC single crystals and was polished. The SiC wafer was checked in Raman scattering spectroscopy characteristic, then, the wafer had a poly type of 6H-SiC. Besides, emission distribution on a plane of the wafer was checked by radiating He-Cd laser (325 nm) to the SiC wafer, then, the SiC wafer had the same poly type of 6H-SiC at whole surface thereof.

While the present invention has been shown and described with reference to the foregoing preferred embodiment, it will be apparent to those skilled in the art that changes in form and detail may be therein without departing from the scope of the invention as defined in the appended claims.

## Claims

1. A manufacturing method for producing silicon carbide single crystals, comprising:
providing a silicon carbide single-crystal substrate (34) as a seed crystal (34) in a crucible (30);
introducing a mixture gas having a gas including Si and a gas including C into said crucible, whereby silicon carbide single crystals grow on said silicon carbide single-crystal substrate, **characterized in that**:
a temperature gradient occurs in an inlet conduit (50) for introducing the mixture gas so that a temperature of the inlet conduit rises at a portion of the inlet conduit that is closer to the crucible,
wherein the temperature gradient in the inlet conduit is set at 100°C/cm or more on an average from an end portion in the inlet conduit that is disposed at the crucible to a portion at 500 °C in the inlet conduit.

2. A manufacturing method for producing silicon carbide single crystals according to claim 1, wherein:
a conduit having a hole whose sectional area is smaller at a portion thereof that is closer to the crucible as the inlet conduit.

3. A manufacturing method for producing silicon carbide single crystals according to claim 1 or 2, wherein:
a temperature gradient in the inlet conduit is set at 500°C/cm or more on an average from an end portion in the inlet conduit that is disposed at the crucible to a portion at 500 °C in the inlet conduit.

4. A manufacturing method for producing silicon carbide single crystals according to any one of claims 1 to 3, wherein: a flow velocity of the mixture gas at an end portion of the inlet conduit that is disposed at a side of the crucible is set at 50 cm/s or more.

5. A manufacturing method for producing silicon carbide single crystals according to any one of claims 1 to 4, wherein: a flow velocity of the mixture gas at an end portion of the inlet conduit that is disposed at a side of the crucible is set at 500 cm/s or more.

6. A manufacturing method for producing silicon carbide single crystals according to claim 1,
**characterized in that**:
the mixture gas is mixed with a carrier gas, then, the mixture gas and the carrier gas are introduced into crucible through an inlet conduit (50) for introducing the mixture gas into the crucible.

7. A manufacturing method for producing silicon carbide single crystals according to claim 6, wherein:
a flow rate including the mixture gas and the carrier gas in the inlet conduit is bigger than that of a gas composed only of the mixture gas in the inlet conduit.

8. A manufacturing method for producing silicon carbide single crystals according to claim 6 or 7, wherein:
the carrier gas is composed at least one of hydrogen and inert gas.

9. A manufacturing method for producing silicon carbide single crystals according to any one of claims 1 to 8, wherein
a temperature at an exhaust portion of the crucible through which the mixture gas is introduced into the crucible is set higher than that at an introducing portion of the crucible through which the mixture gas is exhausted from the crucible.

10. A manufacturing method for producing silicon carbide single crystals according to any one of claims 1 to 9, further **characterized by**
checking a portion in the crucible where deposits caused by the mixture gas are formed using an x-ray apparatus provided outside of the crucible; and
rising a temperature of the portion in the crucible with a temperature rising means (9) provided outside of the crucible, which is movable with respect to the crucible, by shifting the temperature rising means.

11. A manufacturing method for producing silicon carbide single crystals according to any one of claims 1 to 10, further **characterized by**
passing the mixture gas that is exhausted from a growth room (35) where growth of silicon carbide single crystals on the silicon carbide single-crystal substrate is performed in the crucible through a room (40),
wherein a temperature of the room is set lower than that of the growth room.

12. A manufacturing apparatus for producing silicon carbide single crystals comprising:
a crucible (30) for disposing a silicon carbide single-crystal substrate (34) therein as a seed crystal (34),
wherein
an inlet conduit (50) for introducing a mixture gas having a gas including Si and a gas including C into the crucible,so that silicon carbide single crystals grow on said silicon carbide single-crystal substrate, into the crucible; the inlet conduit having a first heat insulator (51) provided at a halfway portion of the inlet conduit for setting the temperature gradient in the inlet conduit at 100°C/cm or more on an average from an end portion in the inlet conduit that is disposed at the crucible to a portion at 500°C in the inlet conduit.

13. A manufacturing apparatus for producing silicon carbide single crystals according to claim 12, wherein:
materials composed of the inlet conduit (50) are arranged in order of graphite, quartz, and metal from an outlet portion (50d) where the mixture gas is exhausted into the crucible.

14. A manufacturing apparatus for producing silicon carbide single crystals according to claim 12 and/or 13, wherein:
a sectional area of a hole of the inlet conduit (50) is reduced at a portion of the inlet conduit that is closer to the crucible.

15. A manufacturing apparatus for producing silicon carbide single crystals according to any one of claims 12 to 14, wherein:
a second heat insulator (52) is provided between the inlet conduit and the crucible.

16. A manufacturing apparatus for producing silicon carbide single crystals according to any one of claims 12 to 15, wherein:
the surface roughness Ra is 7 µm or less at least at an inner surface of an outlet portion (50d) in the inlet conduit where the mixture gas is exhausted from the inlet conduit to the crucible.

17. A manufacturing apparatus for producing silicon carbide single crystals according to any one of claims 12 to 16, wherein:
TaC is formed on an inner surface of an outlet portion (50d) in the inlet conduit where the mixture gas is exhausted from the inlet conduit to the crucible, and a surface roughness Ra of the TaC is 7 µm or less.

18. A manufacturing apparatus for producing silicon carbide single crystals according to claim 16 or 17, wherein:
the inner surface of the outlet portion in the inlet conduit has a polished surface.

19. A manufacturing apparatus for producing silicon carbide single crystals according to any of claims 16 to 18, wherein: the inner surface of the outlet portion in the inlet conduit has a mirror surface.

20. A manufacturing apparatus for producing silicon carbide single crystals according to claim 18 or 19, wherein: a surface roughness Ra of the inner surface of the outlet portion in the inlet conduit has a polished surface is 1 µm or less.

21. A manufacturing apparatus for producing silicon carbide single crystals according to claim 12, wherein
a protrusion (38) is formed inside the crucible so as to protrude to a side of the silicon carbide single-crystal substrate, the protrusion having a communicating path (38a) which connects the inlet conduit (50) to introduce the mixture gas into the crucible to a growth room (35) where growth of silicon carbide single crystals on the silicon carbide single-crystal substrate is performed in the crucible;
wherein an opening area of the communicating path increases at a portion of the communicating path that is closer to the silicon carbide single-crystal substrate, and a wall surface of the communicating path has a convex and concavity thereon.

22. A manufacturing apparatus for producing silicon carbide single crystals according to claim 12, further
**characterized by**
a structure in which a temperature at an exhaust portion of the crucible through which the mixture gas is exhausted from the crucible is higher than that at an introducing portion of the crucible through which the mixture gas is introduced into the crucible.

23. A manufacturing apparatus for producing silicon carbide single crystals according to claim 12, further
**characterized by**
a temperature rising means (9) movably disposed outside the crucible; and
an x-ray apparatus disposed outside the crucible.

24. A manufacturing apparatus for producing silicon carbide single crystals according to claim 12, further
**characterized by**
a room (40) for passing the mixture gas therein that is exhausted from a growth room (35) where growth of silicon carbide single crystals on the silicon carbide single-crystal substrate is performed in the crucible,
wherein a temperature of the room is set lower than that of the growth room.

## Patentansprüche

1. Herstellungsverfahren zur Herstellung von Siliciumcarbid-Einkristallen, umfassend:
Zur-Verfügung-Stellen eines Siliciumcarbid-Einkristallsubstrats (34) als einen Impfkristall (34) in einem Tiegel (30);
Einleiten eines Mischgases mit einem Si enthaltenden Gas und einem C enthaltenden Gas in den Tiegel, wodurch auf dem Siliciumcarbid-Einkristallsubstrat Siliciumcarbid-Einkristalle wachsen,
**dadurch gekennzeichnet, dass**:
in einem Einleitrohr (50) zum Einleiten des Mischgases ein Temperaturgradient auftritt, so dass eine Temperatur des Einleitrohrs an einem Abschnitt des Einleitrohrs, der sich näher am Tiegel befindet, ansteigt,
wobei der Temperaturgradient in dem Einleitrohr im Mittel von einem Endabschnitt im Einleitrohr, der am Tiegel angeordnet ist, zu einem Abschnitt mit 500 °C in dem Einleitrohr auf 100 °C/cm eingestellt wird.

2. Herstellungsverfahren zur Herstellung von Siliciumcarbid-Einkristallen nach Anspruch 1, wobei:
als Einleitrohr ein Rohr verwendet wird, das ein Loch aufweist, dessen Querschnittsfläche an einem Abschnitt davon, der sich näher am Tiegel befindet, kleiner ist.

3. Herstellungsverfahren zur Herstellung von Siliciumcarbid-Einkristallen nach Anspruch 1 oder 2, wobei:
ein Temperaturgradient in dem Einleitrohr im Mittel von einem Endabschnitt im Einleitrohr, der am Tiegel angeordnet ist, zu einem Abschnitt mit 500 °C im Einleitrohr auf 500 °C/cm eingestellt wird.

4. Herstellungsverfahren zur Herstellung von Siliciumcarbid-Einkristallen nach einem der Ansprüche 1 bis 3, wobei:
eine Strömungsgeschwindigkeit des Mischgases an einem Endabschnitt des Einleitrohrs, der an einer Seite des Tiegels angeordnet ist, auf 50 cm/s oder höher eingestellt wird.

5. Herstellungsverfahren zur Herstellung von Siliciumcarbid-Einkristallen nach einem der Ansprüche 1 bis 4, wobei:
eine Strömungsgeschwindigkeit des Mischgases an einem Endabschnitt des Einleitrohrs, der an einer Seite des Tiegels angeordnet ist, auf 500 cm/s oder höher eingestellt wird.

6. Herstellungsverfahren zur Herstellung von Siliciumcarbid-Einkristallen nach Anspruch 1, **dadurch gekennzeichnet, dass**:
das Mischgas mit einem Trägergas vermischt wird, das Mischgas und das Trägergas dann durch ein Einleitrohr (50) zum Einleiten des Mischgases in den Tiegel in den Tiegel eingeleitet werden.

7. Herstellungsverfahren zur Herstellung von Siliciumcarbid-Einkristallen nach Anspruch 6, wobei:
eine Durchflussrate, welche das Mischgas und das Trägergas einschließt, in dem Einleitrohr höher ist als die eines lediglich aus dem Mischgas bestehenden Gases in dem Einleitrohr.

8. Herstellungsverfahren zur Herstellung von Siliciumcarbid-Einkristallen nach Anspruch 6 oder 7, wobei:
das Trägergas aus zumindest einem von Wasserstoff und Inertgas besteht.

9. Herstellungsverfahren zur Herstellung von Siliciumcarbid-Einkristallen nach einem der Ansprüche 1 bis 8, wobei:
eine Temperatur an einem Auslassabschnitt des Tiegels, durch den das Mischgas in den Tiegel eingeleitet wird, höher eingestellt wird als die an einem Einleitabschnitt des Tiegels, durch den das Mischgas aus dem Tiegel
abgeleitet wird.

10. Herstellungsverfahren zur Herstellung von Siliciumcarbid-Einkristallen nach einem der Ansprüche 1 bis 9, welches ferner **dadurch** charakterisiert ist, dass
ein Abschnitt des Tiegels, bei dem durch das Mischgas verursachte Ablagerungen gebildet werden, unter Verwendung einer Röntgenvorrichtung, die außerhalb des Tiegels bereitgestellt wird, kontrolliert wird; und
eine Temperatur des Abschnitts im Tiegel mit einem Temperaturerhöhungsmittel (9), das außerhalb des Tiegels bereitgestellt wird, welches in Bezug auf den Tiegel bewegbar ist, durch Verschieben des Temperaturerhöhungsmittels erhöht wird.

11. Herstellungsverfahren zur Herstellung von Siliciumcarbid-Einkristallen nach einem der Ansprüche 1 bis 10, welches ferner **dadurch** charakterisiert ist, dass
das Mischgas, das aus einem Wachstumsraum (35), in dem das Wachstum der Siliciumcarbid-Einkristalle auf dem Siliciumcarbid-Einkristallsubstrat im Tiegel durchgeführt wird, ausgeleitet wird, durch einen Raum (40) geleitet wird,
wobei eine Temperatur des Raums geringer als die des Wachstumsraums eingestellt wird.

12. Herstellungsvorrichtung zur Herstellung von Siliciumcarbid-Einkristallen, umfassend:
einen Tiegel (30) zum Darinanordnen eines Siliciumcarbid-Einkristallsubstrats (34) als einen Impfkristall (34), mit
einem Einleitrohr (50) in den Tiegel zum Einleiten eines Mischgases mit einem Si enthaltenden Gas und einem C enthaltenden Gas in den Tiegel, so dass Siliciumcarbid-Einkristalle auf dem Siliciumcarbid-Einkristallsubstrat wachsen, wobei das Einleitrohr einen ersten Wärmeisolator (51) aufweist, der an einem Abschnitt in der Mitte des Einleitrohrs vorgesehen ist, zum Einstellen des Temperaturgradienten im Einleitrohr von einem Endabschnitt im Einleitrohr, der am Tiegel angeordnet ist, zu einem Abschnitt mit 500 °C im Einleitrohr auf ein Mittel von 100 °C/cm oder höher.

13. Herstellungsvorrichtung zur Herstellung von Siliciumcarbid-Einkristallen nach Anspruch 12, wobei:
die Materialien, aus denen das Einleitrohr (50) besteht, von einem Auslassabschnitt (50d), bei dem das Mischgas in den Tiegel ausgeleitet wird, in der Reihenfolge Graphit, Quarz und Metall angeordnet sind.

14. Herstellungsvorrichtung zur Herstellung von Siliciumcarbid-Einkristallen nach Anspruch 12 und/oder 13, wobei:
eine Querschnittsfläche eines Loches des Einleitrohrs (50) bei einem Abschnitt des Einleitrohrs, der sich näher am Tiegel befindet, verringert ist.

15. Herstellungsvorrichtung zur Herstellung von Siliciumcarbid-Einkristallen nach einem der Ansprüche 12 bis 14, wobei:
ein zweiter Wärmeisolator (52) zwischen dem Einleitrohr und dem Tiegel vorgesehen ist.

16. Herstellungsvorrichtung zur Herstellung von Siliciumcarbid-Einkristallen nach einem der Ansprüche 12 bis 15, wobei:
die Oberflächenrauheit Ra an einer Innenoberfläche des Auslassabschnitts (50d) des Einleitrohrs, bei dem das Mischgas aus dem Einleitrohr zu dem Tiegel ausgeleitet wird, 7 µm oder weniger beträgt.

17. Herstellungsvorrichtung zur Herstellung von Siliciumcarbid-Einkristallen nach einem der Ansprüche 12 bis 16, wobei:
auf einer Innenoberfläche eines Auslassabschnitts (50d) des Einleitrohrs, bei dem das Mischgas aus dem Einleitrohr zu dem Tiegel ausgeleitet wird, TaC gebildet wird und eine Oberflächenrauheit Ra des TaC gleich 7 µm oder weniger beträgt.

18. Herstellungsvorrichtung zur Herstellung von Siliciumcarbid-Einkristallen nach Anspruch 16 oder 17, wobei:
die Innenoberfläche des Auslassabschnitts des Einleitrohrs eine polierte Oberfläche aufweist.

19. Herstellungsvorrichtung zur Herstellung von Siliciumcarbid-Einkristallen nach einem der Ansprüche 16 bis 18, wobei:
die Innenoberfläche des Auslassabschnitts im Einleitrohr eine Spiegeloberfläche aufweist.

20. Herstellungsvorrichtung zur Herstellung von Siliciumcarbid-Einkristallen nach Anspruch 18 oder 19, wobei:
eine Oberflächenrauheit Ra der Innenoberfläche des Auslassabschnitts im Einleitrohr, die eine polierte Oberfläche aufweist, 1 µm oder weniger beträgt.

21. Herstellungsvorrichtung zur Herstellung von Siliciumcarbid-Einkristallen nach Anspruch 12, wobei:
im Innern des Tiegels ein Vorsprung (38) ausgebildet ist, um zu einer Seite des Siliciumcarbid-Einkristallsubstrats herauszuragen, wobei der Vorsprung einen Verbindungspfad (38a) aufweist, der das Einleitrohr (50) zum Einleiten des Mischgases in den Tiegel mit einem Wachstumsraum (35) verbindet, wo ein Wachstum von Siliciumcarbid-Einkristallen auf dem Siliciumcarbid-Einkristallsubstrat im Tiegel durchgeführt wird;
wobei eine Öffnungsfläche des Verbindungspfads bei einem Abschnitt des Verbindungspfads, der sich näher am Siliciumcarbid-Einkristallsubstrat befindet, ansteigt und eine Wandoberfläche des Verbindungspfads eine konvexe und konkave Form aufweist.

22. Herstellungsvorrichtung zur Herstellung von Siliciumcarbid-Einkristallen nach Anspruch 12, welche ferner charakterisiert ist durch:
einen Aufbau, bei dem eine Temperatur bei einem Auslassabschnitt des Tiegels, durch den das Mischgas aus dem Tiegel ausgeleitet wird, höher ist als die bei einem Einlassabschnitt des Tiegels, durch den das Mischgas in den Tiegel eingeleitet wird.

23. Herstellungsvorrichtung zur Herstellung von Siliciumcarbid-Einkristallen nach Anspruch 12, welche ferner charakterisiert ist durch:
ein Temperaturerhöhungsmittel (9), das außerhalb des Tiegels bewegbar vorgesehen ist; und
eine außerhalb des Tiegels vorgesehene Röntgenvorrichtung.

24. Herstellungsvorrichtung zur Herstellung von Siliciumcarbid-Einkristallen nach Anspruch 12, welche ferner charakterisiert ist durch:
einen Raum (40) zum Durchleiten des Mischgases, das aus einem Wachstumsraum (35) ausgeleitet wird, wo ein Wachstum von Siliciumcarbid-Einkristallen auf dem Siliciumcarbid-Einkristallsubstrat im Tiegel durchgeführt wird,
wobei eine Temperatur des Raums geringer eingestellt ist als die des Wachstumsraums.

## Revendications

1. Procédé de fabrication pour la production de monocristaux de carbure de silicium comprenant les étapes consistant à :
fournir un substrat de monocristal de carbure de silicium (34) en tant que germe cristallin (34) dans un creuset (30) ;
introduire un mélange de gaz comportant un gaz contenant du Si et un gaz contenant du C dans ledit creuset, moyennant quoi les monocristaux de carbure de silicium croissent sur ledit substrat de monocristal de carbure de silicium,
**caractérisé en ce que** :
un gradient de température est créé dans une conduite d'amenée (50) pour introduire le mélange de gaz de telle sorte qu'une température de la conduite d'amenée s'élève au niveau d'une partie de la conduite d'amenée qui est plus proche du creuset,
dans lequel le gradient de température dans la conduite d'amenée est fixée à 100° C/cm ou plus sur une moyenne à partir d'une partie d'extrémité dans la conduite d'amenée qui est disposée au niveau du creuset jusqu'à une partie à 500° C dans la conduite d'amenée.

2. Procédé de fabrication pour la production de monocristaux de carbure de silicium selon la revendication 1, dans lequel :
une conduite ayant un trou dont la section est plus petite au niveau d'une partie de celle-ci qui est plus proche du creuset en tant que conduite d'amenée.

3. Procédé de fabrication pour la production de monocristaux de carbure de silicium selon la revendication 1 ou 2, dans lequel : un gradient de température dans la conduite d'amenée est fixé à 500° C/cm ou plus sur une moyenne à partir d'une partie d'extrémité dans la conduite d'amenée qui est disposée au niveau du creuset jusqu'à une partie à 500° C dans la conduite d'amenée.

4. Procédé de fabrication pour la production de monocristaux de carbure de silicium selon l'une quelconque des revendications 1 à 3, dans lequel : une vitesse d'écoulement du mélange de gaz au niveau d'une partie d'extrémité dans la conduite d'amenée qui est disposée au niveau d'un côté du creuset est fixée à 50 cm/s ou plus.

5. Procédé de fabrication pour la production de monocristaux de carbure de silicium selon l'une quelconque des revendications 1 à 4, dans lequel : une vitesse d'écoulement du mélange de gaz au niveau d'une partie d'extrémité de la conduite d'amenée qui est disposée au niveau d'un côté du creuset est fixée à 500 cm/s ou plus.

6. Procédé de fabrication pour la production de monocristaux de carbure de silicium selon la revendication 1,
**caractérisé en ce que** :
le mélange de gaz est mélangé avec un gaz porteur, puis le mélange de gaz et le gaz porteur sont introduits dans le creuset par l'intermédiaire d'une conduite d'amenée (50) afin d'introduire le mélange de gaz dans le creuset.

7. Procédé de fabrication pour la production de monocristaux de carbure de silicium selon la revendication 6, dans lequel :
un débit incluant le mélange de gaz et le gaz porteur dans la conduite d'amenée est supérieur à celui d'un gaz composé uniquement du mélange de gaz dans la conduite d'amenée.

8. Procédé de fabrication pour la production de monocristaux de carbure de silicium selon la revendication 6 ou 7, dans lequel :
le gaz porteur est composé au moins d'un gaz hydrogène et d'un gaz inerte.

9. Procédé de fabrication pour la production de monocristaux de carbure de silicium selon l'une quelconque des revendications 1 à 8, dans lequel :
une température d'une partie d'échappement du creuset par l'intermédiaire de laquelle le mélange de gaz est introduit dans le creuset est fixée à une valeur supérieure à celle d'une partie d'introduction du creuset par l'intermédiaire de laquelle le mélange de gaz est évacué du creuset.

10. Procédé de fabrication pour la production de monocristaux de carbure de silicium selon l'une quelconque des revendications 1 à 9, **caractérisé en outre par** :
une vérification d'une partie dans le creuset où les dépôts provoqués par le mélange de gaz sont formés en utilisant un appareil à rayons X, prévu à l'extérieur du creuset ; et
une élévation de la température de la partie dans le creuset avec un moyen d'élévation de la température (9) prévu à l'extérieur du creuset, qui peut être déplacé par rapport au creuset, en décalant le moyen d'élévation de la température.

11. Procédé de fabrication pour la production de monocristaux de carbure de silicium selon l'une quelconque des revendications 1 à 10, **caractérisé en outre par** :
le passage du mélange de gaz qui est évacué d'une chambre de croissance (35) où la croissance des monocristaux de carbure de silicium sur le substrat de monocristal de carbure de silicium est réalisée dans le creuset à travers une chambre (40),
dans lequel une température de la chambre est fixée à une valeur inférieure à celle de la chambre de croissance.

12. Appareil de fabrication pour la production de monocristaux de carbure de silicium comprenant :
un creuset (30) pour y disposer à l'intérieur un substrat de monocristal de carbure de silicium (34) en tant que germe cristallin (34), dans lequel
une conduite d'amenée (50) pour introduire un mélange de gaz comportant un gaz contenant du Si et un gaz contenant du C dans le creuset, de telle sorte que les monocristaux de carbure de silicium croissent sur ledit substrat de monocristal de carbure de silicium, dans le creuset ; la conduite d'amenée (50) ayant un premier isolant thermique (51), prévu au niveau d'une partie à mi-parcours de la conduite d'amenée pour fixer le gradient de température dans la conduite d'amenée à 100° C/cm ou plus sur une moyenne à partir d'une partie d'extrémité de la conduite d'amenée qui est disposée au niveau du creuset jusqu'à une partie à 500° C dans la conduite d'amenée.

13. Appareil de fabrication pour la production de monocristaux de carbure de silicium selon la revendication 12, dans lequel :
les matériaux composés de la conduite d'amenée (50) sont disposés dans l'ordre graphite, quartz et métal à partir d'une partie de sortie (50d) où le mélange de gaz est évacué dans le creuset.

14. Appareil de fabrication pour la production de monocristaux de carbure de silicium selon la revendication 12 et/ou 13, dans lequel :
une section d'un trou de la conduite d'amenée (50) est réduite au niveau d'une partie de la conduite d'amenée qui est plus proche du creuset.

15. Appareil de fabrication pour la production de monocristaux de carbure de silicium selon l'une quelconque des revendications 12 à 14, dans lequel :
un deuxième isolant thermique (52) est prévu entre la conduite d'amenée et le creuset.

16. Appareil de fabrication pour la production de monocristaux de carbure de silicium selon l'une quelconque des revendications 12 à 15, dans lequel :
la rugosité de surface Ra est égale ou inférieure à 7 µm au moins au niveau d'une surface interne d'une partie de sortie (50d) dans la conduite d'amenée où le mélange de gaz est évacué depuis la conduite d'amenée jusqu'au creuset.

17. Appareil de fabrication pour la production de monocristaux de carbure de silicium selon l'une quelconque des revendications 12 à 16, dans lequel :
le TaC est formé sur une surface interne d'une partie de sortie (50d) dans la conduite d'amenée où le mélange de gaz est évacué à partir de la conduite d'amenée jusqu'au creuset, et une rugosité de surface Ra du TaC est de 7 µm ou moins.

18. Appareil de fabrication pour la production de monocristaux de carbure de silicium selon la revendication 16 ou 17, dans lequel : la surface interne de la partie de sortie dans la conduite d'amenée a une surface polie.

19. Appareil de fabrication pour la production de monocristaux de carbure de silicium selon l'une quelconque des revendications 16 à 18, dans lequel : la surface interne de la partie de sortie dans la conduite d'amenée a une surface spéculaire.

20. Appareil de fabrication pour la production de monocristaux de carbure de silicium selon la revendication 18 ou 19, dans lequel : une rugosité de surface Ra de la surface interne de la partie de sortie dans la conduite d'amenée qui a une surface polie est égale ou inférieure à 1 µm.

21. Appareil de fabrication pour la production de monocristaux de carbure de silicium selon la revendication 12, dans lequel une protubérance (38) est formée à l'intérieur du creuset de manière à faire saillie dans la direction d'un côté du substrat de monocristal de carbure de silicium, la protubérance ayant un chemin de communication (38a) qui connecte la conduite d'amenée (50) pour introduire le mélange de gaz dans le creuset à une chambre de croissance (35) où la croissance des monocristaux de carbure de silicium sur le substrat de monocristal de carbure de silicium est réalisée dans le creuset ;
dans lequel une zone d'ouverture du chemin de communication augmente au niveau d'une partie du chemin de communication qui est plus proche du substrat de monocristal de carbure de silicium, et une surface de paroi a une convexité et une concavité sur le dessus.

22. Appareil de fabrication pour la production de monocristaux de carbure de silicium selon la revendication 12,
**caractérisé en outre par :**
une structure dans laquelle une température au niveau d'une partie d'échappement du creuset par l'intermédiaire de laquelle le mélange de gaz est évacué du creuset est plus élevée que celle au niveau d'une partie d'introduction du creuset par l'intermédiaire de laquelle le mélange de gaz est introduit dans le creuset.

23. Appareil de fabrication pour la production de monocristaux de carbure de silicium selon la revendication 12, **caractérisé en outre par** :
un moyen d'élévation de la température (9) disposé à l'extérieur du creuset, de manière à pouvoir être déplacé ; et
un appareil à rayons X disposé à l'extérieur du creuset.

24. Appareil de fabrication pour la production de monocristaux de carbure de silicium selon la revendication 12,
**caractérisé en outre par** :
une chambre (40) pour y faire passer le mélange de gaz à l'intérieur qui est évacué depuis une chambre de croissance (35) où la croissance des monocristaux de carbure de silicium sur le substrat de monocristal de carbure de silicium est réalisée dans le creuset, dans laquelle une température de la chambre est fixée à une valeur inférieure à celle de la chambre de croissance.
